# EUROPEAN PATENT APPLICATION

(11) **EP 4 443 745 A1**
(43) Date of publication of application: **09.10.2024**
(21) Application number: 22963811.9
(22) Date of filing: 01.11.2022
(51) Int. Cl.: H03F 1/02

(54) **DOHERTY AMPLIFIER AND OUTPUT NETWORK THEREFOR, AND DESIGN METHOD FOR DOHERTY AMPLIFIER**

(71) Applicant: Suzhou Watech Electronics Co., Ltd., Suzhou, Jiangsu 215125 (CN)
(72) Inventor: LIU, Haoyu, Shanghai 200127 (CN); ZHENG, Shuangshuang, Shanghai 200127 (CN); LIN, Liang, Shanghai 200127 (CN)
(74) Representative: Michalski Hüttermann & Partner Patentanwälte mbB
(86) International application number: PCT/CN2022/128906
(87) International publication number: WO 2024/092492

(57) **Abstract**

Embodiments of the present application provide an output network for a Doherty amplifier. The output network includes a combination node, a primary output network, an auxiliary output network, and a combined matching network. The primary output network includes a first sub-network and a second sub-network connected in series, and the auxiliary output network includes a third sub-network, a fourth sub-network, and a fifth sub-network connected in series. The first sub-network and the third sub-network have the same circuit topology and each at least includes an inductor and a capacitor. The fourth sub-network is connected between the third sub-network and the fifth sub-network. The second sub-network, the fourth sub-network, and the fifth sub-network have the same circuit topology and each at least includes one of an inductor, a capacitor, and a transmission line. The combined matching network is configured such that node impedance at the combination node is complex impedance, and the primary output network and the auxiliary output network are configured such that the node impedance matches a target load impedance of a primary amplifier and an auxiliary amplifier.

## Description

### TECHNICAL FIELD

The present disclosure relates to the field of wireless communications, more particularly to an output network of a Doherty amplifier, a Doherty amplifier comprising the output network, and a design method of the Doherty amplifier.

### BACKGROUND

With the development of wireless communication technology, the communication bandwidth required by wireless communication systems continues to increase, and the modulation signals used in wireless communication systems are becoming more and more complex. In order to meet the requirements of bandwidth, efficiency, and size of wireless communication systems, in the radio frequency front-terminal system of wireless communication networks, the efficiency, back-off power range, operating bandwidth, and size of the power amplifier (PA) are more and more demanding.

In related arts, Doherty amplifiers can be employed in the radio frequency front-terminal of wireless communication systems (comprising base stations, broadcasts, mobile terminals, etc.) to improve the efficiency of wireless communication systems. However because the number of radio frequency link units (power amplifiers and antennas, etc.) comprised by the radio frequency front-terminal systems continues to increase, and the Doherty amplifier has many components and a large circuit size, it is difficult to meet the design requirements of miniaturized amplifiers. In addition, because the load modulation of the Doherty amplifier is implemented by a quarter-wavelength transmission line, this structure leads to a narrow operating bandwidth and a small back-off power range in high-efficiency of the Doherty amplifier. Therefore, it is difficult for wireless communication systems to meet the increasingly high requirements in terms of bandwidth, efficiency, and size with the conventional Doherty amplifiers. At present, there are some methods to increase the bandwidth by improving the load modulation network of the Doherty amplifier, but the size of the Doherty amplifier is generally increased, which makes it difficult to achieve a good balance between the efficiency, bandwidth, back-off power range and circuit size of the amplifier.

### SUMMARY

In view of the above, the present disclosure provides an output network for a Doherty amplifier, a Doherty amplifier comprising the output network, and a design method of the Doherty amplifier to mitigate, decrease, or even eliminate the above problems.

The embodiments of the present disclosure provide an output network for a Doherty amplifier, the Doherty amplifier comprising a main amplifier and an auxiliary amplifier, the output network comprising a combination node, a main output network connected between an output port of the main amplifier and the combination node, a auxiliary output network connected between the output port of the auxiliary amplifier and the combination node, and a merging matching network connected between the combination node and a radio frequency output port of the Doherty amplifier, where the main output network comprises a first sub-network and a second sub-network connected in series, the auxiliary output network comprises a third sub-network, a fourth sub-network and a fifth sub-network connected in series, the first sub-network and the third sub-network have the same circuit topology and each at least comprise an inductor and a capacitor, the fourth sub-network is connected between the third sub-network and the fifth sub-network, and the second sub-network, the fourth sub-network, and the fifth sub-network have the same circuit topology and each at least comprise one of an inductor, a capacitor, and a transmission line, where the merging matching network is configured for the node impedance at the combination node being a complex impedance, and the main output network and the auxiliary output network are configured for the node impedance matching with goal load impedances of the main amplifier and the auxiliary amplifier.

According to some embodiments of the present disclosure, the main output network is equivalent to a first transmission line in an operating frequency band, and the auxiliary output network is equivalent to a second transmission line in the operating frequency band, and an electrical angle θ_{M} of the first transmission line and an electrical angle θ_{A} of the second transmission line satisfy: 70°<θ_{M}<90°, and 135°<θ_{A}<180°.

According to some embodiments of the present disclosure, the output network is configured for an output current I_{M} of the main amplifier and an output current I_{A} of the auxiliary amplifier to satisfy: an amplitude of I_{M} is not larger than an amplitude of I_{A}, and a phase difference between I_{M} and I_{A} is less than 90°.

According to some embodiments of the present disclosure, the first sub-network and the third sub-network each comprise a first capacitor and a first inductor, one end of the first capacitor being connected to an output port of the main amplifier or the auxiliary amplifier, the other end of the first capacitor being grounded, one end of the first inductor being connected to an output port of the main amplifier or the auxiliary amplifier, and the other end of the first inductor being connected to an input port of the second sub-network or the fourth sub-network.

According to some embodiments of the present disclosure, the first sub-network and the third sub-network each further comprise a second capacitor and a third transmission line, the third transmission line being connected between the first inductor and a DC voltage port, one end of the second capacitor being connected to the DC voltage port and the other end of the second capacitor being grounded, and the DC voltage port being configured to provide a DC bias voltage to the main amplifier or the auxiliary amplifier via the third transmission line and the first inductor.

According to some embodiments of the present disclosure, the first sub-network and the third sub-network each comprise a second inductor, a third inductor, a third capacitor, and a fourth capacitor, one end of the third capacitor being connected to an output port of the main amplifier or the auxiliary amplifier, the other end of the third capacitor being grounded, one end of the second inductor being connected to an output port of the main amplifier or the auxiliary amplifier, the other end of the second inductor and one end of the third inductor being connected to one end of the fourth capacitor, the other end of the fourth capacitor being grounded, and the other end of the third inductor being connected to an input port of the second sub-network or the fourth sub-network.

According to some embodiments of the present disclosure, the first sub-network and the third sub-network each comprise a fourth inductor, a fifth inductor, a fifth capacitor, and a sixth capacitor, one end of the fifth capacitor being connected to an output port of the main amplifier or the auxiliary amplifier, the other end of the fifth inductor being grounded, one end of the fourth inductor being connected to the output port of the main amplifier or the auxiliary amplifier, the other end of the fourth inductor being connected to the DC voltage port, one end of the sixth capacitor being connected to the DC voltage port, the other end of the sixth capacitor being grounded, one end of the fifth inductor connected to the output port of the main amplifier or the auxiliary amplifier, the other end of the fifth inductor connected to the input port of the second sub-network or the fourth sub-network, and the DC voltage port configured to provide a DC bias voltage to the main amplifier or the auxiliary amplifier via the fourth inductor.

According to some embodiments of the present disclosure, the second sub-network and the fourth sub-network each comprise a sixth inductor and a seventh capacitor, one end of the sixth inductor being connected to an output port of the first sub-network or the third sub-network, the other end of the sixth inductor being connected to one end of the seventh capacitor, and the other end of the seventh capacitor grounded.

According to some embodiments of the present disclosure, the second sub-network and the fourth sub-network further comprise a seventh inductor, a T-shaped circuit is formed by the sixth inductor, the seventh inductor, and the seventh capacitor.

According to some embodiments of the present disclosure, the second sub-network and the fourth sub-network further comprise an eighth capacitor, a π-type circuit is formed by the eighth capacitor, the sixth inductor, and the seventh capacitor.

According to some embodiments of the present disclosure, the second sub-network and the fourth sub-network comprise a fourth transmission line.

According to some embodiments of the present disclosure, the second sub-network and the fourth sub-network further comprise a ninth capacitor connected between the fourth transmission line and the ground.

According to some embodiments of the present disclosure, the merging matching network comprises an eighth inductor and a tenth capacitor, one end of the eighth inductor being connected to the combination node, the other end of the eighth inductor being connected to one end of the tenth capacitor, and the other end of the tenth capacitor being grounded.

According to some embodiments of the present disclosure, the merging matching network further comprises a ninth inductor, one end of the ninth inductor being connected between the eighth inductor and the tenth capacitor, and the other end of the ninth inductor being connected to a DC voltage port configured to provide a DC bias voltage to the main amplifier and the auxiliary amplifier via the ninth inductor, the eighth inductor, the main output network, and the auxiliary output network.

According to some embodiments of the present disclosure, the merging matching network comprises a fifth transmission line, a sixth transmission, and an eleventh capacitor, one end of the fifth transmission line being connected to the combination node, the other end of the fifth transmission line being connected to one end of the sixth transmission line, the other end of the sixth transmission line being connected to a radio frequency output port of the Doherty amplifier, one end of the eleventh capacitor being connected between the fifth transmission line and the sixth transmission line, and the other end of the eleventh capacitor being grounded.

According to some embodiments of the present disclosure, the merging matching network comprises a seventh transmission line, an eighth transmission line, a ninth transmission line, and a twelfth capacitor, one end of the seventh transmission line being connected to the combination node, the other end of the seventh transmission line being connected to one end of the eighth transmission line, the other end of the eighth transmission line being connected to a DC voltage port, one end of the twelfth capacitor being connected to the DC voltage port, the other end of the twelfth capacitor being grounded, one end of the ninth transmission line being connected between the seventh transmission line and the eighth transmission line, the other end of the ninth transmission line connected to a radio frequency output port of the Doherty amplifier, the DC voltage port being configured to provide a DC bias voltage to the main amplifier and the auxiliary amplifier via the eighth transmission line, the seventh transmission line, the main output network and the auxiliary output network.

According to some embodiments of the present disclosure, at least one of the first to the twelfth capacitor is implemented by at least one of a PCB surface mount element and an integrated circuit device, and at least one of the first to the ninth inductor is implemented by at least one of: a PCB surface mount element, an integrated circuit device, a bonding wire, a microstrip line, a metal winding wire, and a transmission line.

According to some embodiments of the present disclosure, at least one of the third to the ninth transmission line is implemented by at least one of: a microstrip line, a strip line, a coplanar waveguide, and a substrate integrated waveguide.

Another embodiment of the present disclosure provides a Doherty amplifier comprising: a main amplifier, an auxiliary amplifier, and an output network according to any of the foregoing embodiments, where the output network is configured to receive a first amplifying signal outputted by the main amplifier and a second amplifying signal outputted by the auxiliary amplifier, and the first amplifying signal and the second amplifying signal are combined at the combination node to be provided to a radio frequency output port of the Doherty amplifier.

Yet another embodiment of the present disclosure provides a design method of a Doherty amplifier, the Doherty amplifier comprising a main amplifier, an auxiliary amplifier, and an output network as claimed in claim 1, where the method comprises: setting a goal performance index of the Doherty amplifier, the goal performance index at least comprising an operating frequency, a saturation power, and a dynamic range of the Doherty amplifier; selecting transistors for the main amplifier and the auxiliary amplifier according to the goal performance index; determining a first goal impedance, a second goal impedance and a third goal impedance based on load traction testing or simulation analysis, where the first goal impedance is a load impedance for maximizing an efficiency of the main amplifier when the Doherty amplifier is in a back-off power state, the second goal impedance is a load impedance for maximizing the efficiency of the main amplifier when an output power of the main amplifier reaches the saturation power, and the third goal impedance is a load impedance for maximizing the efficiency of the auxiliary amplifier when an output power of the auxiliary amplifier reaches the saturation power; according to the first goal impedance, the second goal impedance and the third goal impedance, determining a circuit topology and element parameters of each sub-network in the main output network and the auxiliary output network and determining a circuit topology and element parameters of the merging matching network.

In the output network for the Doherty amplifier according to some embodiments of the present disclosure, a main output network, an auxiliary output network, and a merging matching network are provided, the main output network comprising a first sub-network and a second sub-network connected in series, the auxiliary output network comprising a third sub-network, a fourth sub-network, and a fifth sub-network connected in series, where the merging matching network is configured for the node impedance at the combination node being a complex impedance, and the main output network and the auxiliary output network are configured for the node impedance matching with the goal load impedances of the main amplifier and the auxiliary amplifier, so that the Doherty amplifier can operate efficiently from low power to high power. On the other hand, the first sub-network and the third sub-network have the same circuit topology and each at least comprises an inductor and a capacitor, the fourth sub-network is connected between the third sub-network and the fifth sub-network, the second sub-network, the fourth sub-network, and the fifth sub-network have the same circuit topology and each at least comprises one of an inductor, a capacitor, and a transmission line, thereby conducive to simplify the structure of the output network of the Doherty amplifier and the corresponding design process.

These and other aspects of the present disclosure will be clearly understood in accordance with the embodiments described herein and will be elucidated with reference to the embodiments described herein.

### BRIEF DESCRIPTION OF THE DRAWINGS

In the following description of exemplary embodiments in conjunction with the drawings, further details, features, and advantages of the technical proposal of the present disclosure are disclosed, in the drawings:
Fig. 1 schematically shows an exemplary schematic diagram of a Doherty amplifier in the related art;
Fig. 2 schematically shows an exemplary schematic diagram of an output network of a Doherty amplifier according to some embodiments of the present disclosure;
Fig. 3 schematically shows an exemplary schematic diagram of the output network of Fig. 2 implementing load modulation at low power according to some embodiments of the present disclosure;
Fig. 4 schematically shows an exemplary schematic diagram of the output network of Fig. 2 implementing load modulation at high power according to some embodiments of the present disclosure;
Fig. 5 schematically shows an exemplary circuit topology of a first sub-network and a third sub-network according to some embodiments of the present disclosure;
Fig. 6 schematically shows an exemplary circuit topology of a second sub-network, a fourth sub-network, and a fifth sub-network according to some embodiments of the present disclosure;
Fig. 7 schematically shows an exemplary circuit topology diagram of a merging matching network according to some embodiments of the present disclosure;
Fig. 8 schematically shows an exemplary schematic diagram of the Doherty amplifier according to some embodiments of the present disclosure;
Fig. 9 schematically shows a flowchart of a design method of the Doherty amplifier according to some embodiments of the present disclosure;
Fig. 10 schematically shows an exemplary schematic diagram of the Doherty amplifier designed by the method of Fig. 9 according to some embodiments of the present disclosure;
Fig. 11 schematically shows an exemplary schematic diagram of the Doherty amplifier designed by the method of Fig. 9 according to other embodiments of the present disclosure;
Fig. 12 schematically shows a performance example diagram of the Doherty amplifier according to some embodiments of the present disclosure; and
Fig. 13 schematically shows a performance example diagram of the Doherty amplifier according to some embodiments of the present disclosure.

### DETAILED DESCRIPTION OF THE EMBODIMENTS

Several embodiments of the present disclosure will be described in more detail below with reference to the drawings in order to enable one skilled in the art to implement the technical proposal of the present disclosure. The technical proposals of the present disclosure may be embodied in many different forms and purposes and should not be limited to the embodiments described herein. These embodiments are provided in order to make the technical proposal of the present disclosure clear and complete, but the embodiments do not limit the scope of protection of the present disclosure.

Unless otherwise defined, all terms (comprising technical terms and scientific terms) used herein have the same meanings as those normally understood by those of ordinary skill in the art to which the application relates. It will be further understood that terms such as those defined in commonly used dictionaries should be interpreted as having meanings consistent with their meanings in the relevant field and/or in the context of the specification, and will not be interpreted in an idealized or overly formal sense unless expressly defined herein.

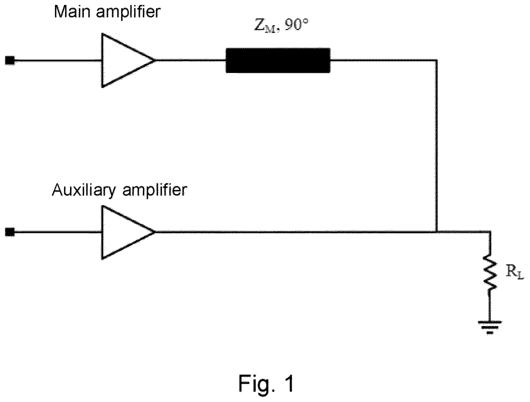

Fig. 1 schematically shows an exemplary schematic diagram of a Doherty amplifier in the related art. As shown in Fig. 1, the Doherty amplifier comprises two amplifiers (a main amplifier and an auxiliary amplifier), the main amplifier and the auxiliary amplifier are respectively connected to two output ports of the power divider (not shown), the radio frequency output port of the main amplifier is connected to a transmission line with an impedance Z_{M} and an electrical length of 90°. (i.e., a quarter-wavelength transmission line), and the auxiliary amplifier is connected to a load R_{L}. In related arts, the main amplifier is operated in Class B or Class AB, and the auxiliary amplifier is operated in Class C. As the input power increases, the current output after the auxiliary amplifier is turned on will modulate the load R_{L}, and then dynamically modulate the two respective loads of the amplifiers (this process is also called "dynamic load modulation"). The two amplifiers are not operated in turn. The main amplifier is operated all the time, and the auxiliary amplifier starts to operate when the input power reaches a set peak. The quarter-wavelength transmission line in the output path of the main amplifier can play the role of phase compensation, so that the output signal in the output path of the main amplifier and the output signal in the output path of the auxiliary amplifier have the same phase at the merging point.

With the continuous development of communication technology, multiple-input multiple-output (MIMO) systems are more and more widely applied. The radio frequency front-terminal system of MIMO systems comprises multiple (for example, dozens or even hundreds) radio frequency link units, which puts forward higher and higher requirements for the miniaturized design of power amplifiers in radio frequency link units. However, the conventional proposal makes it difficult to meet the design requirements of miniaturized amplifiers due to the high complexity, many components, and large circuit size.

On the other hand, the increase in circuit components brings more problems to the integrated design of power amplifiers, not only does the design difficulty increase, the overall circuit size increases, and the chip cost increases, but the circuit loss becomes larger, and the efficiency of power amplifiers will also decrease, which makes it more difficult to design a high-efficiency, energy-saving, and low-cost system.

In addition, with the continuous iteration of the communication system, the communication bandwidth is multiplying increased. For example, in the 5G scenario, the communication bandwidth has reached 500MHz or even higher, which provides a high challenge to the operating bandwidth of the power amplifier. In Fig. 1, the load modulation of the Doherty amplifier is realized by a quarter-wavelength transmission line, and this structure has only a narrow operating bandwidth (often less than 200MHz), so this architecture is far from meeting the requirements of today's system broadband operation.

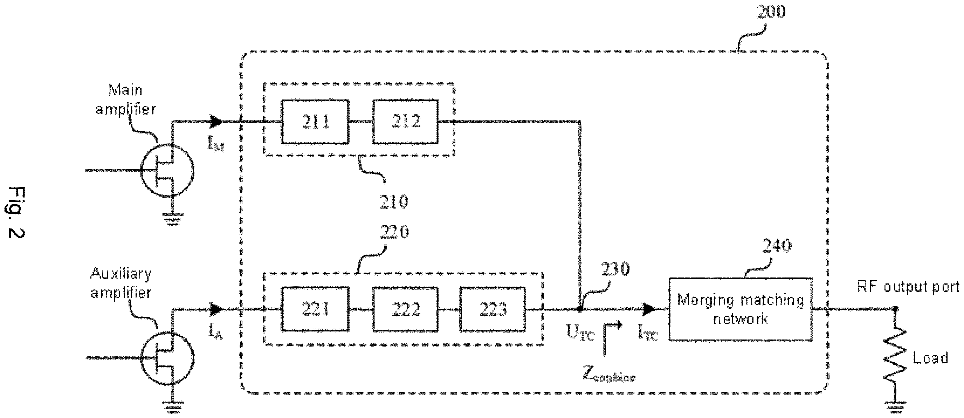

Fig. 2 schematically shows an exemplary schematic diagram of an output network 200 of a Doherty amplifier according to some embodiments of the present disclosure. As shown in Fig. 2, the output network 200 comprises a combination node 230, a main output network 210 connected between an output port of the main amplifier of the Doherty amplifier and the combination node 230, an auxiliary output network 220 connected between an output port of the auxiliary amplifier of the Doherty amplifier and the combination node 230, and a merging matching network 240 connected between the combination node 230 and a radio frequency output port of the Doherty amplifier.

Exemplarily, the main output network 210 comprises a first sub-network 211 and a second sub-network 212 connected in series, the auxiliary output network 220 comprises a third sub-network 221, a fourth sub-network 222 and a fifth sub-network 223 connected in series, where the first sub-network 211 and the third sub-network 221 have the same circuit topology and each at least comprise an inductor and a capacitor, the fourth sub-network 222 is connected between the third sub-network 221 and the fifth sub-network 223, the second sub-network 212, the fourth sub-network 222 and the fifth sub-network 223 have the same circuit topology and each at least comprise one of inductor, capacitor and transmission line, the merging matching network 240 is configured for the node impedance at the combination node 230 being a complex impedance Z_{combine}, and the main output network 210 and the auxiliary output network 220 are configured for the node impedance matching with the goal load impedances of the main amplifier and the auxiliary amplifier.

As shown in Fig. 2, Z_{combine} is the equivalent impedance viewed from the combination node 230 toward the merging matching network 240, and in some cases can be considered as the ratio of the voltage U_{TC} at the combination node 230 to the current I_{TC} flowing into the merging matching network 240. The merging matching network 240 can comprise an appropriate type and number of circuit components so long as the circuit components make the node impedance at the combing node 230 a complex impedance Z_{combine}. For example, the merging matching network 240 may comprise an LC circuit causing the load at the radio frequency output port of the Doherty amplifier (e.g., R_{L} in Fig. 1) to be converted to a complex impedance Z_{combine}, so that the node impedance at the combination node 230 is a complex impedance Z_{combine}.

It should be noted that in the present disclosure, the expression "A and B have the same circuit topology" indicates that A and B comprise the same type and the same number of circuit elements (devices or components) and that the connection relationship between these circuit elements in A and B is also the same. For example, the first sub-network 211, and the third sub-network 221 having the same circuit topology can both comprise an LC circuit or an LLC circuit. In addition, although the first sub-network 211 and the third sub-network 221 have the same circuit topology, this does not mean that the element parameters of the first sub-network 211 and the third sub-network 221 are also the same. Similarly, for the second sub-network 212, the fourth sub-network 222, and the fifth sub-network 223, the element parameters thereof are not necessarily the same. For example, the second sub-network 212, the fourth sub-network 222, and the fifth sub-network 223 each comprise an LC circuit, but the values of the inductor and the capacitor in each sub-network are not the same.

In the embodiment shown in Fig. 2, the first sub-network 211 and the second sub-network 212 form the main output network 210, and the third sub-network 221, the fourth sub-network 222, and the fifth sub-network 223 form the auxiliary output network 220, but this does not exclude the case where the main output network 210 and the auxiliary output network 220 comprise other elements. For example, in other embodiments, the main output network 210 can also comprise other circuit components, such as capacitors for isolating direct current (DC). Likewise, the auxiliary output network 220 can also comprise other circuit components, such as capacitors for isolating DC. Alternatively or additionally, the main output network 210 can also comprise other sub-networks, such as one or more sixth sub-networks (the circuit topology thereof can be the same as the second sub-network 212), The auxiliary output network 220 can also comprise other sub-networks, such as one or more seventh sub-networks (the circuit topology thereof can be the same as the fourth sub-network 222).

In addition, the combination node 230 indicates a common connection point of the main output network 210, the auxiliary output network 220, and the merging matching network 240. Exemplarily, the combination node 230 can be a common electrical contact joint of the main output network 210, the auxiliary output network 220, and the merging matching network 240, the combination node 230 can also be an electrical node of the output port of the main output network 210, the combination node 230 can also be an electrical node of the output port of the auxiliary output network 220, and even the combination node 230 can be an electrical node of the input port of the merging matching network 240.

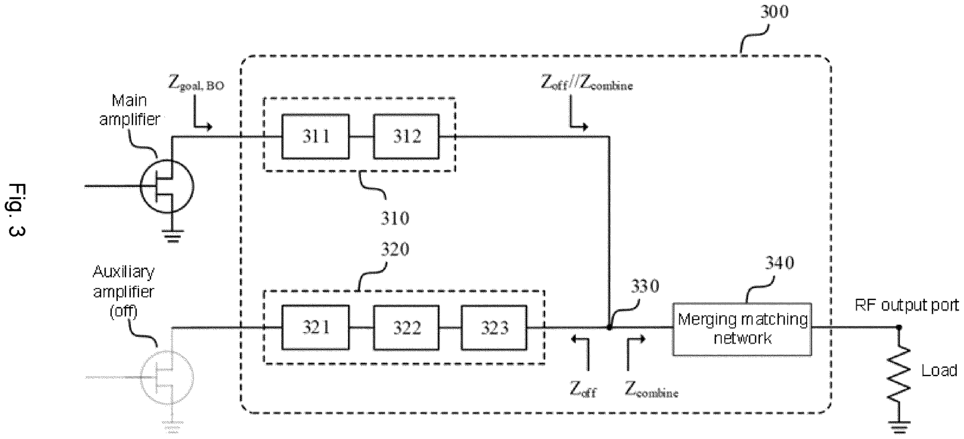

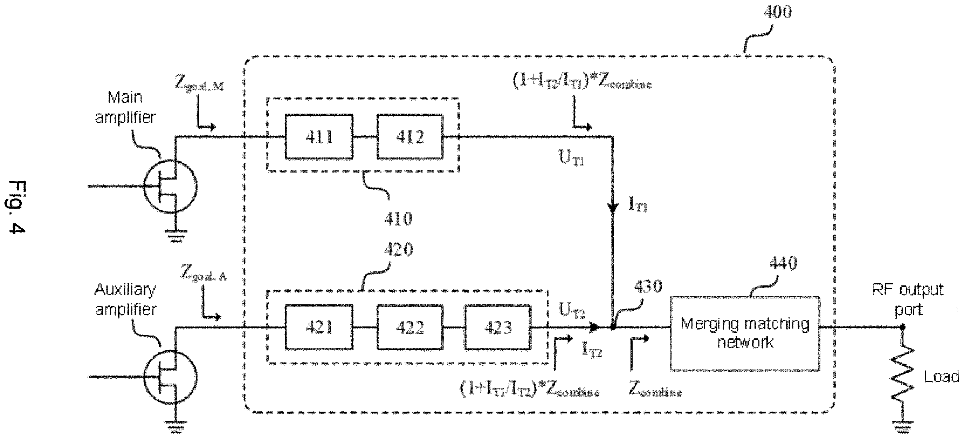

Specifically, the impedance matching process of the output network 200 will be illustrated below with reference to Figs. 3 and 4.

As shown in Fig. 3, at low power, the auxiliary amplifier is not turned on, so it can be equivalent to an open state. At this time, the branch of the auxiliary output network 320 (hereinafter referred to as the auxiliary path) provides the auxiliary path impedance Z_{off} at the combination node 330, to be connected in parallel with the node impedance Z_{combine} at one end of the branch of the main output network 310 (hereinafter referred to as the main path). At the back-off power, the main output network 310 can convert the parallel impedance Z_{off}//Z_{combine} of the auxiliary path impedance Z_{off} and the node impedance Z_{combine} to the goal load impedance of the main amplifier at the back-off power (Z_{goal}, _{BO} in Fig. 3). For the main amplifier or the auxiliary amplifier (typically implemented as a transistor), the goal load impedance indicates the optimal power-matched impedance of the amplifier at a particular power level, that is, the load impedance capable of maximizing the efficiency of the amplifier at a particular power level. The goal load impedance depends on the parameters and the actual power level of the amplifier, can be obtained by theoretical calculation or simulation analysis, and can also be obtained by experimental methods (such as load traction test). The main output network 310 converts the parallel impedance Z_{off}//Z_{combine} to the goal load impedance Z_{goal}, _{BO} of the main amplifier at the back-off power, so that the main amplifier can still operate efficiently at the back-off power.

As shown in Fig. 4, when the auxiliary amplifier is turned on at high power, the current flowing through the auxiliary path is I_{T2}, and the current flowing through the main path is I_{T1}. According to Kirchhoffs voltage law and Kirchhoffs current law, it can be obtained that at this time the combined equivalent impedance of the main path is (1+I_{T2}/I_{T1})*Z_{combine}, and the combined equivalent impedance of the auxiliary path is (1+I_{T1}/I_{T2})*Z_{combine}, so the current I_{T2} can dynamically modulate the combined equivalent impedance of the main path and the combined equivalent impedance of the auxiliary path. At saturation power, the main output network 410 (comprising the first sub-network 411 and the second sub-network 412) can convert the combined equivalent impedance (1 +I_{T2}/I_{T1})*Z_{combine} of the main path to the goal load impedance of the main amplifier at saturation power (Z_{goal, M} in Fig. 4). The auxiliary output network 420 (comprising the third sub-network 421, the fourth sub-network 422, and the fifth sub-network 423) can convert the combined equivalent impedance (1+I_{T1}/I_{T2})*Z_{combine} of the auxiliary path into the goal load impedance of the auxiliary amplifier at saturation power (Z_{goal, A} in Fig. 4). The main output network 410 and the auxiliary output network 420 can make both the main amplifier and the auxiliary amplifier operate efficiently at saturation power by converting the combined equivalent impedance of the main path and the combined equivalent impedance of the auxiliary path into the corresponding goal load impedances of the main amplifier and the auxiliary amplifier at saturation power respectively.

The "combined equivalent impedance" referred to herein indicates the equivalent impedance viewed from a combination node (i.e., combination node 430) on a path. Exemplarily, as shown in Fig. 4, the combined equivalent impedance of the main path is the ratio of the main path output terminal voltage U_{T1} to the main path output current I_{T1}, and the combined equivalent impedance of the auxiliary path is the ratio of the auxiliary path output terminal voltage U_{T2} to the auxiliary path output current I_{T2}.

In the present disclosure, the main amplifier and auxiliary amplifier can comprise and are not limited to, for example, VDMOS, LDMOS, or GaN-based power transistors, with different transistor technologies providing different performance advantages in terms of output power, gain, and performance. For example, the type of transistor can be selected according to the requirements of frequency, bandwidth, cost, etc. According to some embodiments of the present disclosure, the main amplifier and the auxiliary amplifier can be the same type of power transistor (such as a GaN-based power transistor), and the parameters and dimensions of the transistor serving as the main amplifier and the transistor serving as the auxiliary amplifier can be exactly the same. In other embodiments, the transistor serving as main amplifiers and the transistor serving as auxiliary amplifiers differ in at least one aspect of transistor type, parameters, size, and the like. According to further embodiments of the present disclosure, the main amplifier or the auxiliary amplifier can comprise a plurality of transistors. There are no specific restrictions on the specific embodiments of the main amplifier and the auxiliary amplifier herein.

With the output network 200 shown in Fig. 2 applied in the Doherty amplifier, the node impedance Z_{combine} at the combination node 230 can be matched to the goal load impedances of the main amplifier and the auxiliary amplifier of the Doherty amplifier at different power levels, so that the main amplifier can still operate efficiently at the back-off power, and both the main amplifier and the auxiliary amplifier can operate efficiently at the saturation power, that is, the Doherty amplifier can operate efficiently at different power levels. On the other hand, the first sub-network 211 and the third sub-network 221 have the same circuit topology and each at least comprises an inductor and a capacitor, and the second sub-network 212, the fourth sub-network 222 and the fifth sub-network 223 have the same circuit topology and each at least comprises one of an inductor, a capacitor, and a transmission line, thereby conducive to simplifying the structure of the output network of the Doherty amplifier and the corresponding design process. In addition, as will be further described below, by reasonably setting the circuit topology and component parameters of each sub-network in the main output network 210 and the auxiliary output network 220, the Doherty amplifier can operate with high efficiency while having a larger operating bandwidth and a deeper back-off power (that is, a larger back-off power range).

In some embodiments, the main output network can be equivalent to the first transmission line TL₁ in the operating frequency band, the auxiliary output network can be equivalent to the second transmission line TL₂ in the operating frequency band, and the electrical angle θ_{M} of the first transmission line TL₁ and the electrical angle θ_{A} of the second transmission line TL₂ satisfy 70°<θ_{M}<90°, and 135°<θ_{A}<180°. The above range can be achieved by appropriately selecting the circuit topology and element parameters of the main output network and the auxiliary output network. Taking the output network 200 shown in Fig. 2 as an example, in particular, by selecting the circuit topology and element parameters of the first sub-network 211, the second sub-network 212, the third sub-network 221, the fourth sub-network 222 and the fifth sub-network 223, the transmission lines (the first transmission line TL₁ and the second transmission line TL₂) equivalent to the main output network 210 and the auxiliary output network 220 in the operating frequency band can have corresponding characteristic impedances and electrical lengths, and the electrical angles θ_{M} of the first transmission line TL₁ and the electrical angle θ_{A} of the second transmission line TL₂ can be made to satisfy the above range. The above range is conducive to enabling Doherty amplifiers to operate at high efficiency while having larger operating bandwidth and deeper back-off power.

In some embodiments, the output network can be configured for the output current I_{M} of the main amplifier and the output current I_{A} of the auxiliary amplifier to satisfy: the amplitude of the I_{M} is not larger than the amplitude of the I_{A}, and the phase difference between the I_{M} and I_{A} is less than 90°, that is, the phase of the I_{A} minus the phase of the I_{M} results in less than 90°. Similar to the above, the above constraints on I_{M} and I_{A} can be achieved by appropriately selecting the circuit topology and the component parameters of the main output network and the auxiliary output network, which is conducive to enabling the Doherty amplifier to operate at high efficiency while having a larger operating bandwidth and a deeper back-off power.

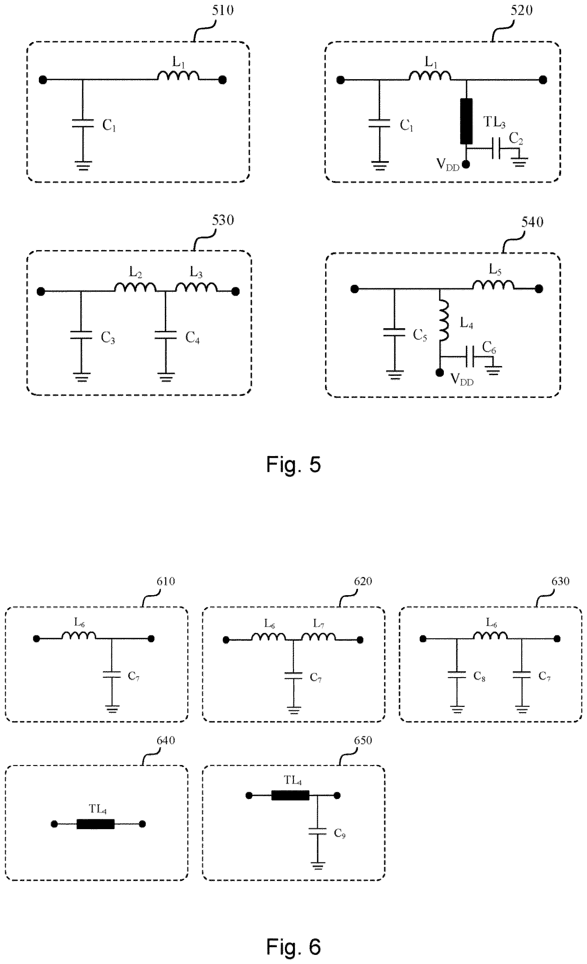

Fig. 5 schematically shows an exemplary circuit topology of a first sub-network and a third sub-network according to some embodiments of the present disclosure.

As shown in Fig. 5, in some embodiments, the first sub-network and the third sub-network can have a circuit topology 510, that is, each comprises a first capacitor C₁ and a first inductor L₁. One end of the first capacitor C₁ is connected to the output port of the main amplifier or the auxiliary amplifier (i.e., one end of the first capacitor C₁ in the first sub-network is connected to the output port of the main amplifier, and one end of the first capacitor C₁ in the third sub-network is connected to the output port of the auxiliary amplifier), the other end of the first capacitor C1 is grounded, and one end of the first inductor L₁ connected to the output port of the main amplifier or the auxiliary amplifier (i.e., one end of the first inductor L₁ in the first sub-network is connected to the output port of the main amplifier, and one end of the first inductor L₁ in the third sub-network is connected to the output port of the auxiliary amplifier), and the other end of the first inductor L₁ is connected to the input port of the second sub-network or the fourth sub-network (i.e., one end of the first inductor L₁ in the first sub-network is connected to the input port of the second sub-network, and one end of the first inductor L₁ in the third sub-network is connected to the input port of the fourth sub-network).

In some embodiments, the first sub-network and the third sub-network can have a circuit topology 520, that is, relative to the circuit topology 510, each further comprises a second capacitor C₂ and a third transmission line TL₃. The third transmission line TL₃ is connected between the first inductor L₁ and a DC voltage port, one end of the second capacitor C₂ is connected to a DC voltage port, and the other end of the second capacitor C₂ is grounded, and the DC voltage port is configured to provide a DC bias voltage V_{DD} to the main amplifier or the auxiliary amplifier via the third transmission line TL₃ and the first inductor L₁.

In some embodiments, the first sub-network and the third sub-network can have a circuit topology 530, that is, each comprises a second inductor L₂, a third inductor L₃, a third capacitor C₃, and a fourth capacitor C₄. One end of the third capacitor C₃ is connected to the output port of the main amplifier or the auxiliary amplifier (i.e., one end of the third capacitor C₃ in the first sub-network connected to the output port of the main amplifier and one end of the third capacitor C₃ in the third sub-network connected to the output port of the auxiliary amplifier), the other end of the third capacitor C₃ is grounded. One end of the second inductor L₂ is connected to the output of the main amplifier or the auxiliary amplifier (i.e., one end of the second inductor L₂ in the first sub-network connected to the output port of the main amplifier and one end of the second inductor L₂ in the third sub-network connected to the output port of the auxiliary amplifier), and the other end of the second inductor L₂ and one end of the third inductor L₃ are connected to one end of the fourth capacitor C₄, the other end of the fourth capacitor C₄ is grounded, and the other end of the third inductor L₃ is connected to the input port of the second sub-network or the fourth sub-network (i.e., the other end of the third inductor L₃ in the first sub-network is connected to the input port of the second sub-network, and the other end of the third inductor L₃ in the third sub-network is connected to the input port of the fourth sub-network).

In some embodiments, the first sub-network and the third sub-network can have a circuit topology 540, that is, each comprises a fourth inductor L₄, a fifth inductor L₅, a fifth capacitor C₅, and a sixth capacitor C₆. One end of the fifth capacitor C₅ is connected to the output port of the main amplifier or the auxiliary amplifier (i.e., one end of the fifth capacitor C₅ in the first sub-network connected to the output port of the main amplifier and one end of the fifth capacitor C₅ in the third sub-network connected to the output port of the auxiliary amplifier), and the other end of the fifth capacitor C₅ is grounded. One end of the fourth inductor L₄ is connected to the output port of the main amplifier or the auxiliary amplifier (i.e., one end of the fourth inductor L₄ in the first sub-network connected to the output port of the main amplifier and one end of the fourth inductor L₄ in the third sub-network connected to the output port of the auxiliary amplifier), and the other end of the fourth inductor L₄ is connected to the DC voltage port. One end of the sixth capacitor C₆ is connected to a DC voltage port, and the other end of the sixth capacitor C₆ is grounded. One end of the fifth inductor L₅ is connected to the output port of the main amplifier or the auxiliary amplifier (i.e., one end of the fifth inductor L₅ in the first sub-network is connected to the output port of the main amplifier and one end of the fifth inductor L₅ in the third sub-network is connected to the output port of the auxiliary amplifier), and the other end of the fifth inductor L₅ is connected to the input port of the second sub-network or the fourth sub-network (i.e., the other end of the fifth inductor L₅ in the first sub-network is connected to the input port of the second sub-network and the other end of the fifth inductor L₅ in the third sub-network is connected to the input port of the fourth sub-network). The DC voltage port is configured to provide a DC bias voltage V_{DD} to the main amplifier or the auxiliary amplifier via the fourth inductor L₄.

Fig. 6 schematically shows an exemplary circuit topology of the second sub-network, the fourth sub-network, and the fifth sub-network according to some embodiments of the present disclosure.

As shown in Fig. 6, in some embodiments, taking the second sub-network and the fourth sub-network as an example, the second and fourth sub-networks can have a circuit topology 610, that is, each comprises a sixth inductor L₆ and a seventh capacitor C₇. One end of the sixth inductor L₆ is connected to the output port of the first sub-network or the third sub-network (i.e., one end of the sixth inductor L₆ in the second sub-network is connected to the output port of the first sub-network and one end of the sixth inductor L₆ in the fourth sub-network is connected to the output port of the third sub-network), the other end of the sixth inductor L₆ is connected to one end of the seventh capacitor C₇, and the other end of the seventh capacitor C₇ is grounded.

In some embodiments, the second sub-network and the fourth sub-network can have a circuit topology 620, that is, relative to the circuit topology 610, each further comprises a seventh inductor L₇. The seventh inductor L₇, the sixth inductor L₆, and the seventh capacitor C₇ form a T-shaped circuit.

In some embodiments, the second sub-network and the fourth sub-network can have a circuit topology 630, that is, relative to the circuit topology 610, each further comprises an eighth capacitor C₈. The eighth capacitor C₈, the sixth inductor L₆, and the seventh capacitor C₇ form a π-type circuit.

In some embodiments, the second sub-network and the fourth sub-network can have a circuit topology 640, that is, each comprises a fourth transmission line TL₄.

In some embodiments, the second sub-network and the fourth sub-network can have a circuit topology 650, that is, relative to the circuit topology 640, each further comprises a ninth capacitor C₉ connected between the fourth transmission line TL₄ and ground.

It is to be noted that, although not shown in the respective circuit topologies of Figs. 5 and 6, one skilled in the art will understand that at least one of the circuit topologies 510, 520, 530, and 540 shown in Fig. 5 and the circuit topologies 610, 620, 630, 640, and 650 shown in Fig. 6 can comprise other circuit components, such as capacitors for isolating DC.

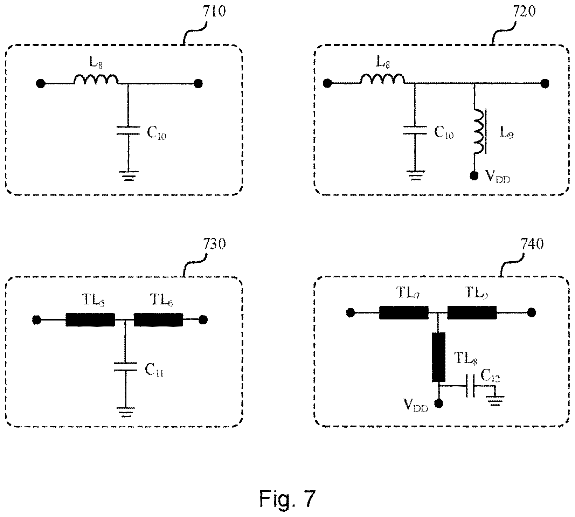

Fig. 7 schematically shows an exemplary circuit topology diagram of a merging matching network according to some embodiments of the present disclosure.

As shown in Fig. 7, in some embodiments, the merging matching network can have a circuit topology 710, that is, the merging matching network comprises an eighth inductor L₈, and a tenth capacitor C₁₀. One end of the eighth inductor L₈ is connected to the combination node, the other end of the eighth inductor L₈ is connected to one end of the tenth capacitor C₁₀, and the other end of the tenth capacitor C₁₀ is grounded.

In some embodiments, the merging matching network can have a circuit topology 720, that is, relative to the circuit topology 710, the merging matching network further comprises a ninth inductor Lg. One end of the ninth inductor L₉ is connected between the eighth inductor L₈ and the tenth capacitor C₁₀, and the other end of the ninth inductor L₅ is connected to a DC voltage port configured to provide a DC bias voltage V_{DD} to the main amplifier and the auxiliary amplifier via the ninth inductor L₉, the eighth inductor L₈, and the main output network and the auxiliary output network.

In some embodiments, the merging matching network can have a circuit topology 730, that is, the merging matching network comprises a fifth transmission line TL₅, a sixth transmission line TL₆, and an eleventh capacitor C₁₁. One end of the fifth transmission line TL₅ is connected to the combination node, the other end of the fifth transmission line TL₅ is connected to one end of the sixth transmission line TL₆, and the other end of the sixth transmission line TL₆ is connected to the radio frequency output port of the Doherty amplifier. One end of the eleventh capacitor C₁₁ is connected between the fifth transmission line TL₅ and the sixth transmission line TL₆, and the other end of the eleventh capacitor C₁₁ is grounded.

In some embodiments, the merging matching network can have a circuit topology 740, that is, the merging matching network comprises a seventh transmission line TL₇, an eighth transmission line TL₈, a ninth transmission line TL₉, and a twelfth capacitor C₁₂. One end of the seventh transmission line TL₇ is connected to the combination node, and the other end of the seventh transmission line TL₇ is connected to one end of the eighth transmission line TL₈, and the other end of the eighth transmission line TL₈ is connected to a DC voltage port. One end of the twelfth capacitor C₁₂ is connected to the DC voltage port, and the other end of the twelfth capacitor C₁₂ is grounded. One end of the ninth transmission line TL₉ is connected between the seventh transmission line TL₇ and the eighth transmission line TL₈, and the other end of the ninth transmission line TL₉ is connected to the radio frequency output port of the Doherty amplifier. The DC voltage port is configured to provide a DC bias voltage V_{DD} to the main amplifier and the auxiliary amplifier via the eighth transmission line TL₈, the seventh transmission line TL₇, the main output network, and the auxiliary output network.

It is to be noted that although not shown in the respective circuit topologies of Fig. 7, one skilled in the art will understand that at least one of the circuit topologies 710, 720, 730, and 740 shown in Fig. 7 can comprise other circuit components, such as capacitors for DC isolation, with which DC signals from the DC voltage port are not transmitted to the radio frequency output port of the Doherty amplifier, so that sensitive radio frequency elements (loads) can be protected from DC power.

Further, in the embodiments described above with respect to Figs. 5 and 7, an associated bias circuit providing a DC bias voltage V_{DD} to the main amplifier and the auxiliary amplifier is disclosed, but this is only a schematic, and one skilled in the art will understand that the number of associated bias circuits and the position thereof in the Doherty amplifier circuit can be adjusted according to practical application. Exemplarily, when the configuration parameters of the main amplifier and the auxiliary amplifier of the Doherty amplifier are not the same (e.g. when they are not the same type of transistor), the associated DC bias circuits can be respectively provided for the main amplifier and the auxiliary amplifier correspondingly. Exemplarily, a corresponding DC bias circuit can be provided in the first sub-network or the second sub-network to provide DC bias for the main amplifier (for example, referring to the circuit topologies 520, 540 above), and a corresponding DC bias circuit can be provided in the third sub-network or the fourth sub-network or the fifth sub-network to provide DC bias for the auxiliary amplifier. Alternatively, the corresponding DC bias circuits can be provided in the merging matching network to provide DC bias for the main amplifier and the auxiliary amplifier (for example, referring to the circuit topologies 720, 740 above).

In some embodiments, at least one of the first to the twelfth capacitor is implemented by at least one of the PCB surface mount elements and integrated circuit device, and at least one of the first to the ninth inductor is implemented by at least one of PCB surface mount element, integrated circuit device, bonding wire, microstrip line, metal winding wire, and transmission line.

In some embodiments, at least one of the third to the ninth transmission line is implemented by at least one of: microstrip line, strip line, coplanar waveguide, substrate integrated waveguide.

Microstrip line is a kind of planar transmission line used most in hybrid microwave integrated circuits and monolithic microwave integrated circuits at present. It is a ribbon conductor (signal line), which is isolated from the ground by a dielectric. Microstrip line can be realized by PCB microstrip line and integrated circuit microstrip line and the like. The factors affecting the characteristic impedance of the microstrip line comprise the thickness, the width, the distance between the microstrip line and the ground, and the dielectric constant of the dielectric, etc. The length of the microstrip line can correspond to the electrical angle of the microstrip line. Exemplarily, at least one of the third to the ninth transmission line can be implemented with the microstrip line. Accordingly, the parameters such as length, width, and the like of the microstrip line can be configured based on characteristic impedances and electrical angles of the respective transmission lines of the third to ninth transmission lines. By using microstrip lines to implement the corresponding transmission lines of the third to ninth transmission lines, transmission lines that meet the requirements of characteristic parameters can be obtained, so that the Doherty amplifier can be made to have a smaller circuit size, higher operating efficiency, larger operating bandwidth, and deeper back-off power (i.e., a larger back-off power range). In particular, the microstrip line can be realized by selecting a substrate with a high dielectric constant to further reduce the size of the associated circuit.

In other embodiments, at least one of the third to ninth transmission lines can comprise a strip line, a coplanar waveguide, or a substrate integrated waveguide. Strip line is a high-frequency transmission wire between dielectrics placed between two parallel grounded planes (or power supply planes). Strip line has the advantages of small size, light weight, wide bandwidth, high quality factor, simple process, low cost, and the like, and is suitable for making high-performance (wide frequency band, high quality factor, high isolation) passive components. Coplanar waveguide (CPW) is constructed by fabricating a central conductor strip on one surface of the dielectric substrate and fabricating a conductor plane on two sides of the central conductor strip. In the millimeter wave band, CPW has lower losses than microstrip and strip line. Substrate integrated waveguide (SIW) has the metal through-holes to realize the field propagation mode of the waveguide on the dielectric substrate, and has the advantages of low differential loss, low radiation, and high quality factor. In some embodiments, at least one of the third to the ninth transmission line can consist of only one of a strip line, a coplanar waveguide, or a substrate integrated waveguide.

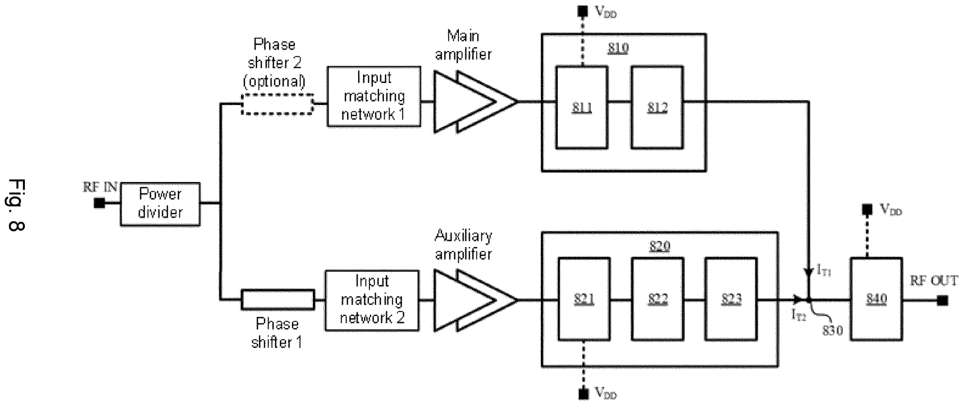

Another embodiment of the present disclosure provides a Doherty amplifier comprising: a main amplifier, an auxiliary amplifier, and an output network according to any of the foregoing embodiments, where the output network is configured to receive a first amplifying signal outputted by the main amplifier and a second amplifying signal outputted by the auxiliary amplifier, and the first amplifying signal and the second amplifying signal are combined at the combination node to be provided to a radio frequency output port of the Doherty amplifier. Since the Doherty amplifier comprises an output network according to the aforementioned embodiment of the present disclosure, the Doherty amplifier has the advantages of the corresponding output network. The Doherty amplifier is described further below with reference to Fig. 8.

As shown in Fig. 8, the radio frequency input signal is connected to the main amplifier and the auxiliary amplifier respectively after passing through the power divider (these amplifiers can be single-stage transistors or multi-stage transistors cascaded), where the input side of the main amplifier and the auxiliary amplifier further comprises an input matching network (that is, the input matching network 1 and the input matching network 2 shown in Fig. 8) and a phase shifter network (that is, the phase shifter 1 and the phase shifter 2 shown in Fig. 8), where the phase shifter network can be only provided in the auxiliary path or in the main path (for example, only in the auxiliary path). The output side of the main amplifier and the auxiliary amplifier is the output network according to any one of the foregoing embodiment of the present disclosure, the output network comprises a main output network 810 and an auxiliary output network 820. The main output network 810 comprises a first sub-network 811 and a second sub-network 812 connected in series, and the auxiliary output network 820 comprises a third sub-network 821, a fourth sub-network 822, and a fifth sub-network 823 connected in series. The merging matching network 840 is configured for the node impedance at the combination node 830 being a complex impedance, and the main output network 810 and the auxiliary output network 820 are configured for the node impedance matching with the goal load impedances of the main amplifier and the auxiliary amplifier. Exemplarily, the (drain) DC bias voltage can be electrically fed via the DC bias circuit in the first sub-network 811 and the third sub-network 821 (or the merging matching network 840).

The first sub-network 811 and the third sub-network 821 can have any of the circuit topologies described above with respect to Fig. 5, and the second sub-network 812, the fourth sub-network 822, and the fifth sub-network 823 can have any of the circuit topologies described above with respect to Fig. 6. By selecting the circuit topology and component parameters of the first sub-network 811, the second sub-network 812, the third sub-network 821, the fourth sub-network 822, and the fifth sub-network 823, the transmission lines equivalent to the main output network 810 and the auxiliary output network 820 in the operating frequency band have corresponding characteristic impedances, electrical lengths, and electrical angles, so that the Doherty amplifier has a large operating bandwidth and a deep back-off power while operating efficiently.

It should be noted that although the Doherty amplifier shown in Fig. 8 comprises only one auxiliary amplifier, one skilled in the art will understand that the Doherty amplifier disclosed in the present disclosure can comprise more auxiliary amplifiers (e.g., two auxiliary amplifiers), and on the basis of the aforementioned embodiments of the present disclosure, a plurality of auxiliary output networks on a plurality of auxiliary paths corresponding to the auxiliary amplifiers can adopt the circuit structure disclosed in the aforementioned embodiments of the present disclosure.

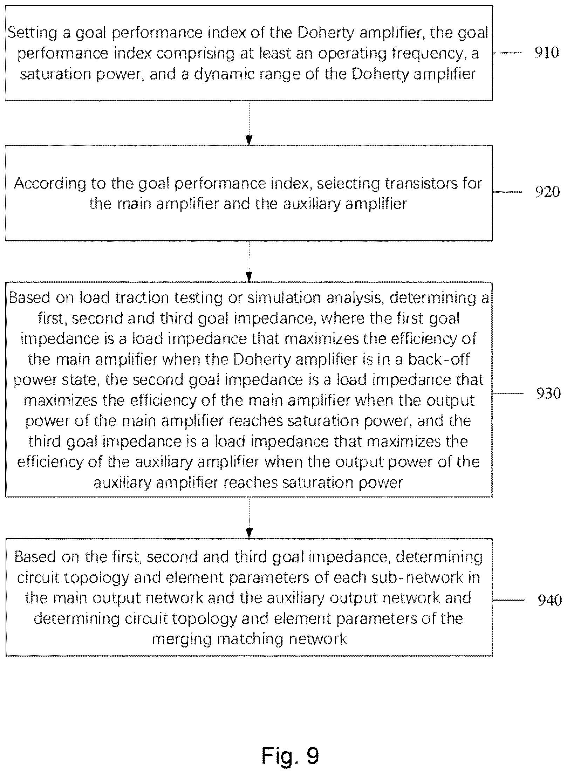

The other embodiments of the present disclosure provide a design method of the Doherty amplifier comprising a main amplifier, an auxiliary amplifier, and an output network 200 described above with respect to Fig. 2. Fig. 9 schematically shows a flow chart 900 of a design method of the Doherty amplifier in accordance with some embodiments of the present disclosure. As shown in Fig. 9, the method comprises the steps of:

Step 910, setting a goal performance index of the Doherty amplifier, the goal performance index comprising at least an operating frequency, a saturation power, and a dynamic range of the Doherty amplifier;

Step 920, according to the goal performance index, selecting transistors for the main amplifier and the auxiliary amplifier. The selecting of transistors can take into account various design requirements, such as power, cost, size, etc., and can refer to the above description of different types of transistors, which is not limited in the disclosure;

Step 930, based on load traction testing or simulation analysis, determining a first, second, and third goal impedance, where the first goal impedance is a load impedance that maximizes the efficiency of the main amplifier when the Doherty amplifier is in a back-off power state, the second goal impedance is a load impedance that maximizes the efficiency of the main amplifier when the output power of the main amplifier reaches saturation power, and the third goal impedance is a load impedance that maximizes the efficiency of the auxiliary amplifier when the output power of the auxiliary amplifier reaches saturation power; and

Step 940, based on the first, second, and third goal impedance, determining the circuit topology and element parameters of each sub-network in the main output network and the auxiliary output network and determining the circuit topology and element parameters of the merging matching network.

With the design method of the Doherty amplifier proposed in the embodiment of the present disclosure, the Doherty amplifier with a more compact structure and a simplified circuit structure and design process can be obtained. In addition, the Doherty amplifier is capable of efficient operation from low power to high power, with deeper back-off power and wider operating bandwidth.

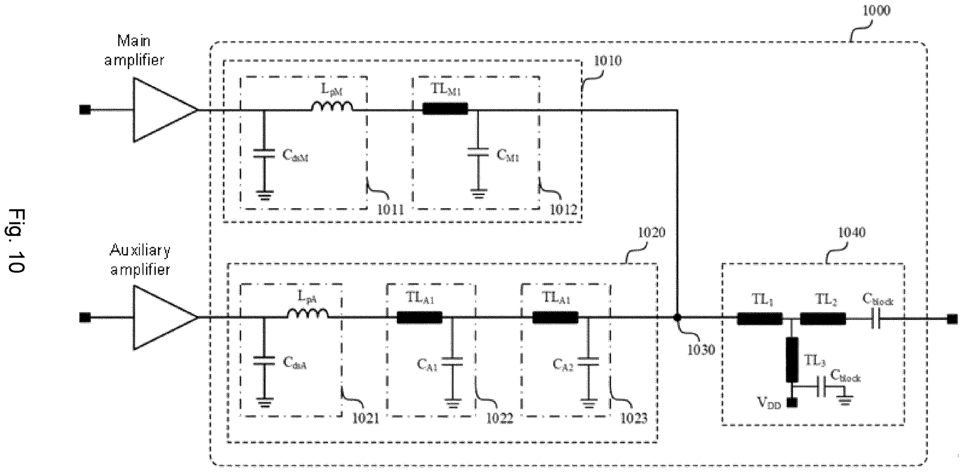

Fig. 10 schematically shows an exemplary schematic diagram of the Doherty amplifier designed by the method of Fig. 9 according to other embodiments of the present disclosure. Considering simplicity, the structure of the input side of the main amplifier and the auxiliary amplifier is omitted. As shown in Fig. 10, the output network 1000 comprises a main output network 1010 comprising a first sub-network 1011 and a second sub-network 1012 connected in series, and an auxiliary output network 1020 comprising a third sub-network 1021, a fourth sub-network 1022, and a fifth sub-network 1023 connected in series. The merging matching network 1040 is configured for the node impedance at the combination node 1030 being a complex impedance, and the main output network 1010 and the auxiliary output network 1020 are configured for the node impedance matching with the goal load impedances of the main amplifier and the auxiliary amplifier. The drain DC bias voltage is electrically fed via a DC bias circuit in the merging matching network 1040.

As shown in Fig. 10, the circuit topology of the first sub-network 1011 and the third sub-network 1021 adopts the circuit topology 510 described above with respect to Fig. 5, the circuit topology of the second sub-network 1012, the fourth sub-network 1022, and the fifth sub-network 1023 adopts the circuit topology 650 described above with respect to Fig. 6, and the merging matching network 1040 adopts the circuit topology 740 described above with respect to Fig. 7 (comprising capacitor C_{block} for isolating DC). As described above, although the circuit topology of different sub-networks can be the same, the element parameters can be different.

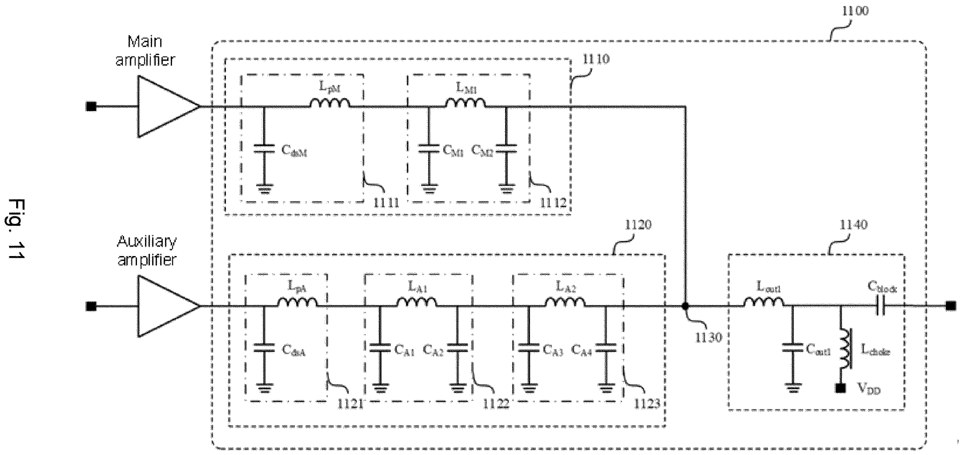

Fig. 11 schematically shows an exemplary schematic diagram of a Doherty amplifier according to other embodiments of the present disclosure designed by the method of Fig. 9 in which the configuration of the input side of the main amplifier and the auxiliary amplifier is likewise omitted. As shown in Fig. 11, the output network 1100 comprises a main output network 1110 comprising a first sub-network 1111 and a second sub-network 1112 connected in series, and an auxiliary output network 1120 comprising a third sub-network 1121, a fourth sub-network 1122, and a fifth sub-network 1123 connected in series. The merging matching network 1140 is configured for the node impedance at the combination node 1130 being a complex impedance, and the main output network 1110 and the auxiliary output network 1120 are configured for the node impedance matching with the goal load impedances of the main amplifier and the auxiliary amplifier. The drain DC bias voltage is electrically fed via a DC bias circuit in the merging matching network 1140.

As shown in Fig. 11, the circuit topology of the first sub-network 1111 and the third sub-network 1121 adopts the circuit topology 510 described above with respect to Fig. 5, the circuit topology of the second sub-network 1112, the fourth sub-network 1122, and the fifth sub-network 1123 adopts the circuit topology 630 described above with respect to Fig. 6, and the merging matching network 1140 adopts the circuit topology 720 described above with respect to Fig. 7 (comprising capacitor C_{block} for isolating DC). As described above, although the circuit topology of different sub-networks can be the same, the element parameters can be different. Specifically, an example of designing parameters of the output network 1100 shown in Fig. 11 is given below:

The Doherty amplifier corresponding to the output network 1100 can be applied to 5G mobile communication systems (2.6GHz frequency band, 32T transmitter array, base station amplifier). The main amplifier is a transistor based on the gallium nitride (GaN) semiconductor process, with a total gate width of 4.8mm, a saturation power of 50W and a parasitic capacitor C_{dsM} of 2pF. The auxiliary amplifier is a transistor based on the gallium nitride (GaN) semiconductor process, with a total gate width of 8.4mm, a saturation power of 85W, and a parasitic capacitor C_{dsA} of 3pF. L_{pM} and L_{pA} are parasitic inductors, both equal to 0.1pF. Other element parameters of each sub-network in the output network 1100 designed by the method of Fig. 9 are as follows:
L_{M1}=1.1 nH;
C_{M1}=1.53 pF;
C_{M2}=3.166 pF;
L_{A1}=0.55 nH;
C_{A1}=3.8 pF;
C_{A2}=6.46 pF;
L_{A2}=0.55 nH;
C_{A3}=6.46 pF;
C_{A4}=5.61 pF;
Lₒᵤₜ₁=2.1 nH;
Cₒᵤₜ₁=6 pF;
L_{choke}= 10 n H;
C_{block}=10 pF.

The radio frequency characteristics of the main output network 1110 in the 2.6GHz frequency band can be equivalent to a transmission line with an electrical length of 86°, and the radio frequency characteristics of the auxiliary output network 1120 in the 2.6GHz frequency band can be equivalent to a transmission line with an electrical length of 161°.

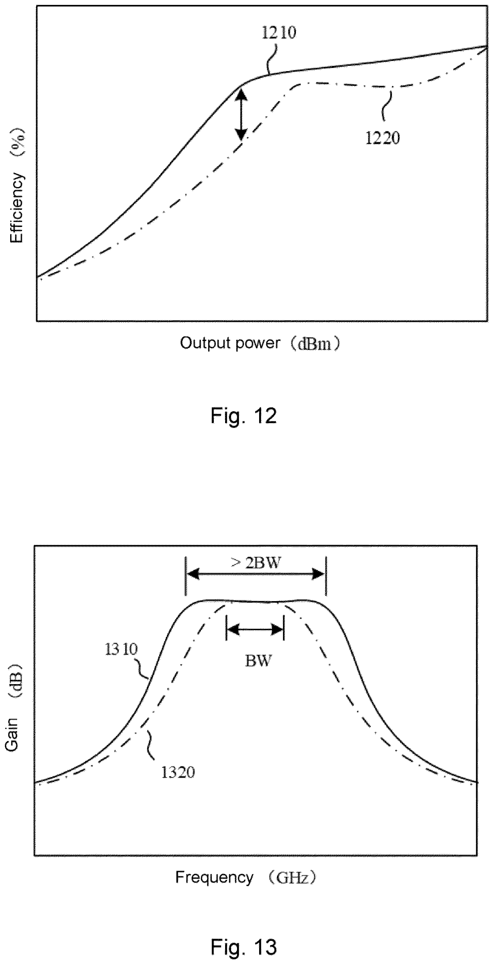

Figs. 12 and 13 schematically show performance diagrams of the Doherty amplifier according to some embodiments of the present disclosure obtained by simulation experiments. As shown in Fig. 12, the amplifier DC-RF conversion efficiency of the Doherty amplifier according to some embodiments of the present disclosure and the conventional Doherty amplifier varies with the output power as shown in curves 1210 and 1220 respectively, and it can be seen that the efficiency of the Doherty amplifier according to some embodiments of the present disclosure is much higher than the conventional proposal in the low output power state. As shown in Fig. 13, the amplifier small signal gains of the Doherty amplifier according to some embodiments of the present disclosure and the conventional Doherty amplifier are shown in curves 1310, 1320 respectively, and it can be seen that the bandwidth of the Doherty amplifier according to some embodiments of the present disclosure is much larger than the conventional Doherty amplifier (more than twice the bandwidth of the conventional Doherty amplifier).

It will be appreciated that while the first, second, third and the like terms can be used herein to describe various devices, elements, components or portions, these devices, elements, components or portions should not be limited by these terms. These terms are used only to distinguish one device, element, component or part from another. The "connected" mentioned in this article comprises "directly connected" or "indirectly connected".

Although the present disclosure has been described in connection with some embodiments, it is not intended to be limited to the particular form described herein. Rather, the scope of this application is limited by the appended claims only. In addition, although individual features can be comprised in different claims, these can be advantageously combined, and inclusion in the different claims does not imply that a combination of features is not feasible and/or advantageous. The order of the features in the claims does not imply that the features must be in any particular order in which they operate. Further, in the claims, the word "comprises" does not exclude other elements, and the term "a" or "an" does not exclude a plurality. The reference numerals in the claims are provided as explicit examples only and should not be construed as limiting the scope of the claims in any way.

## Claims

1. An output network for a Doherty amplifier, the Doherty amplifier comprising a main amplifier and an auxiliary amplifier, the output network comprising:
a combination node;
a main output network connected between an output port of the main amplifier and the combination node;
an auxiliary output network connected between an output port of the auxiliary amplifier and the combination nod; and
a merging matching network connected between the combination node and a radio frequency output port of the Doherty amplifier;
wherein the main output network comprises a first sub-network and a second sub-network connected in series, the auxiliary output network comprises a third sub-network, a fourth sub-network and a fifth sub-network connected in series, the first sub-network and the third sub-network having the same circuit topology and each at least comprising an inductor and a capacitor, the fourth sub-network being connected between the third sub-network and the fifth sub-network, and the second sub-network, the fourth sub-network and the fifth sub-network having the same circuit topology and each at least comprising one of an inductor, a capacitor and a transmission line;
wherein the merging matching network is configured for the node impedance at the combination node being a complex impedance, and the main output network and the auxiliary output network are configured for the node impedance matching with goal load impedances of the main amplifier and the auxiliary amplifier.

2. The output network according to claim 1, wherein the main output network is equivalent to a first transmission line in an operating frequency band, the auxiliary output network is equivalent to a second transmission line in an operating frequency band, and an electrical angle θ_{M} of the first transmission line and an electrical angle θ_{A} of the second transmission line satisfy 70°<θ_{M}<90°, and 135°<θ_{A}<180°.

3. The output network according to claim 1, wherein the output network is configured for an output current I_{M} of the main amplifier and the output current I_{A} of the auxiliary amplifier satisfying an amplitude of the I_{M} is not larger than an amplitude of the I_{A}, and a phase difference between the I_{M} and the I_{A} is less than 90°.

4. The output network according to claim 1, wherein the first sub-network and the third sub-network each comprise a first capacitor and a first inductor, one end of the first capacitor being connected to an output port of the main amplifier or the auxiliary amplifier, the other end of the first capacitor being grounded, one end of the first inductor being connected to an output port of the main amplifier or the auxiliary amplifier, and the other end of the first inductor being connected to an input port of the second sub-network or the fourth sub-network.

5. The output network according to claim 4, wherein the first sub-network and the third sub-network each further comprise a second capacitor and a third transmission line, the third transmission line being connected between the first inductor and a DC voltage port, one end of the second capacitor being connected to the DC voltage port and the other end of the second capacitor being grounded, and the DC voltage port being configured to provide a DC bias voltage to the main amplifier or the auxiliary amplifier via the third transmission line and the first inductor.

6. The output network according to claim 1, wherein, the first sub-network and the third sub-network each comprise a second inductor, a third inductor, a third capacitor, and a fourth capacitor, one end of the third capacitor being connected to an output port of the main amplifier or the auxiliary amplifier, the other end of the third capacitor being grounded, one end of the second inductor being connected to an output port of the main amplifier or the auxiliary amplifier, the other end of the second inductor and one end of the third inductor being connected to one end of the fourth capacitor, the other end of the fourth capacitor being grounded, and the other end of the third inductor being connected to an input port of the second sub-network or the fourth sub-network.

7. The output network according to claim 1, wherein the first sub-network and the third sub-network each comprise a fourth inductor, a fifth inductor, a fifth capacitor, and a sixth capacitor, one end of the fifth capacitor being connected to an output port of the main amplifier or the auxiliary amplifier, the other end of the fifth inductor being grounded, one end of the fourth inductor being connected to the output port of the main amplifier or the auxiliary amplifier, the other end of the fourth inductor being connected to the DC voltage port, one end of the sixth capacitor being connected to the DC voltage port, the other end of the sixth capacitor being grounded, one end of the fifth inductor connected to the output port of the main amplifier or the auxiliary amplifier, the other end of the fifth inductor connected to the input port of the second sub-network or the fourth sub-network, and the DC voltage port configured to provide a DC bias voltage to the main amplifier or the auxiliary amplifier via the fourth inductor.

8. The output network according to claim 1, wherein the second sub-network and the fourth sub-network each comprise a sixth inductor and a seventh capacitor, one end of the sixth inductor being connected to an output port of the first sub-network or the third sub-network, the other end of the sixth inductor being connected to one end of the seventh capacitor, and the other end of the seventh capacitor grounded.

9. The output network according to claim 8, wherein the second sub-network and the fourth sub-network further comprise a seventh inductor, a T-shaped circuit is formed by the sixth inductor, the seventh inductor, and the seventh capacitor.

10. The output network according to claim 8, wherein the second sub-network and the fourth sub-network further comprise an eighth capacitor, a π-type circuit is formed by the eighth capacitor, the sixth inductor, and the seventh capacitor.

11. The output network according to claim 1, wherein the second sub-network and the fourth sub-network each comprise a fourth transmission line.

12. The output network according to claim 11, wherein the second sub-network and the fourth sub-network further comprise a ninth capacitor connected between the fourth transmission line and the ground.

13. The output network according to claim 1, wherein the merging matching network comprises an eighth inductor and a tenth capacitor, one end of the eighth inductor being connected to the combination node, the other end of the eighth inductor being connected to one end of the tenth capacitor, and the other end of the tenth capacitor being grounded.

14. The output network according to claim 13, wherein the merging matching network further comprises a ninth inductor, one end of the ninth inductor being connected between the eighth inductor and the tenth capacitor, and the other end of the ninth inductor being connected to a DC voltage port configured to provide a DC bias voltage to the main amplifier and the auxiliary amplifier via the ninth inductor, the eighth inductor, the main output network, and the auxiliary output network.

15. The output network according to claim 1, wherein the merging matching network comprises a fifth transmission line, a sixth transmission, and an eleventh capacitor, one end of the fifth transmission line being connected to the combination node, the other end of the fifth transmission line being connected to one end of the sixth transmission line, the other end of the sixth transmission line being connected to a radio frequency output port of the Doherty amplifier, one end of the eleventh capacitor being connected between the fifth transmission line and the sixth transmission line, and the other end of the eleventh capacitor being grounded.

16. The output network according to claim 1, wherein the merging matching network comprises a seventh transmission line, an eighth transmission line, a ninth transmission line, and a twelfth capacitor, one end of the seventh transmission line being connected to the combination node, the other end of the seventh transmission line being connected to one end of the eighth transmission line, the other end of the eighth transmission line being connected to a DC voltage port, one end of the twelfth capacitor being connected to the DC voltage port, the other end of the twelfth capacitor being grounded, one end of the ninth transmission line being connected between the seventh transmission line and the eighth transmission line, the other end of the ninth transmission line connected to a radio frequency output port of the Doherty amplifier, the DC voltage port being configured to provide a DC bias voltage to the main amplifier and the auxiliary amplifier via the eighth transmission line, the seventh transmission line, the main output network and the auxiliary output network.

17. The output network according to any one of claims 4 to 16, wherein at least one of the first to the twelfth capacitor is implemented by at least one of a PCB surface mount element and an integrated circuit device; and
wherein at least one of the first to the ninth inductor is implemented by at least one of a PCB surface mount element, an integrated circuit device, a bonding wire, a microstrip wire, a metal winding wire, and a transmission wire.

18. The output network according to any one of claims 5, 11, 15, and 16, wherein at least one of the third to the ninth transmission line is implemented by at least one of a microstrip line, a strip line, a coplanar waveguide, and a substrate integrated waveguide.

19. A Doherty amplifier, comprising:
a main amplifier;
an auxiliary amplifier; and
the output network according to any one of claims 1 to18;
wherein the output network is configured to receive a first amplifying signal outputted by the main amplifier and a second amplifying signal outputted by the auxiliary amplifier, and the first amplifying signal and the second amplifying signal are combined at the combination node to be provided to a radio frequency output port of the Doherty amplifier.

20. A design method of a Doherty amplifier, the Doherty amplifier comprising a main amplifier, an auxiliary amplifier, and an output network according to claim 1, wherein the method comprises:
setting a goal performance index of the Doherty amplifier, the goal performance index comprising at least an operating frequency, a saturation power, and a dynamic range of the Doherty amplifier;
selecting transistors for the main amplifier and the auxiliary amplifier according to the goal performance index;
based on load traction testing or simulation analysis, determining a first goal impedance, a second goal impedance, and a third goal impedance, wherein the first goal impedance is a load impedance maximizing the efficiency of the main amplifier when the Doherty amplifier is in a back-off power state, the second goal impedance is a load impedance maximizing the efficiency of the main amplifier when the output power of the main amplifier reaches saturation power, and the third goal impedance is a load impedance maximizing the efficiency of the auxiliary amplifier when the output power of the auxiliary amplifier reaches saturation power; and
based on the first goal impedance, the second goal impedance, and the third goal impedance, determining a circuit topology and element parameters of each sub-network in the main output network and the auxiliary output network, and determining a circuit topology and element parameters of the merging matching network.
